Europäisches Patentamt

(19) European Patent Office

Office européen des brevets

(11) Publication number : **0 552 506 B1**

# (12) EUROPEAN PATENT SPECIFICATION

(45) Date of publication of patent specification :
05.04.95 Bulletin 95/14

(51) Int. Cl.⁶ : **G01R 13/34,** G09G 1/06, G09G 1/10, G01R 13/22

(21) Application number : **92200188.8**

(22) Date of filing : **23.01.92**

(54) **Method for displaying a waveform of at least one input signal and attribute information on the screen of a cathode ray tube of an oscilloscope, and an oscilloscope for applying the method.**

(43) Date of publication of application :
28.07.93 Bulletin 93/30

(45) Publication of the grant of the patent :
05.04.95 Bulletin 95/14

(84) Designated Contracting States :
CH DE FR GB LI NL

(56) References cited :
EP-A- 0 206 518
EP-A- 0 258 956
FR-A- 2 639 456
GB-A- 2 214 765
US-A- 4 225 940
ELECTRONIQUE RADIO PLANS no. 522, May 1991, PARIS FR pages 47 - 50;'L'oscilloscope numérique HP 54601A'
PATENT ABSTRACTS OF JAPAN vol. 12, no. 436 (P-787)17 November 1988

(73) Proprietor : TEKTRONIX HOLLAND N.V.
73a, Marktweg
NL-8444 AB Heerenveen (NL)

(72) Inventor : Ten Brummelhuis, Folquinus Herman
84, Stjoerboard
NL-8502 AD Joure (NL)

(74) Representative : van der Arend, Adrianus G.A., Ir. et al
van Exter Polak & Charlouis B.V.,
P.O. Box 3241
NL-2280 GE Rijswijk (NL)

## Description

The invention relates to a method according to the preamble of claim 1. The attribute information mentioned therein may be any information which is not waveform information, for example cursors and measurement data.

A method of this sort is known from the digital storage oscilloscope 2211 supplied by Tektronix, Beaverton, Oregon, USA. In this known oscilloscope, the acquisition memory means for each of the input signals to be sampled comprise a separate acquisition memory and the display memory means for every waveform to be displayed and for attribute information to be displayed comprise a separate display memory. A waveform to be displayed may be a reference waveform obtained earlier. The deflection signals supplied to the deflection means of the cathode ray tube depend on which waveform in signal amplitude to time (Yt) display mode, or waveforms in signal amplitude to signal amplitude (XY) display mode and which group of attribute information have to be displayed. For this purpose, complicated control means are needed to write into and read from the display memories. If the data stored in the display memories, in particular of waveforms, were required to be processed, for example for use in a computing algorithm and for displaying the result, this would make the control means still more complicated. Another drawback of the known oscilloscope is that, when the width of a waveform on the screen of the cathode ray tube is expanded, an X-deflection signal (X-sweep signal) is simply amplified, as a result of which inaccuracies or disturbances in the display of both the waveforms and the attribute information become all the more noticeable. Furthermore, to extend or change functions of the oscilloscope, for example in relation to the desired composition of displays, its hardware would have to be altered. In addition, transfer of coordinate data of waveforms to be displayed and obtained by acquisition or by calculation to a receiver outside the oscilloscope presents serious problems. In view of the complexity of this, a microprocessor is therefore used which is specifically intended for carrying out such a transfer.

The object of the invention is to eliminate the drawbacks of the known method.

This object is achieved by means of the method described in claim 1. The memory means can as a result be simply and very flexibly controlled, while a very simple and cheap implementation is made possible which, in terms of hardware, does not have to alter if the number of display functions or specifications of the display functions have to be altered. The alterations can be implemented in a simple manner by altering a program.

The size of the first-in-first-out (FIFO) display memory is essentially determined by the possibility that a discontinuity occurs in the display to be produced on the screen if the display memory becomes empty before a subsequent direct memory transfer (DMA) to the FIFO display memory has occurred. In a practical embodiment, with a display refresh time of 20 ms, it was possible to suffice with a FIFO display memory having only 16 memory locations for displaying an image containing approximately 16000 waveform dots and 1600 attribute information dots.

Where the coordinate data of the waveforms to be displayed and of the attribute information are located in the processor memory is in principle unimportant. For simple programming, data of a particular waveform are, of course, accommodated in a continuous area of coordinate data of the waveform. This can be done in a similar way for groups of associated coordinate data of the attribute information. The sizes of the various areas may vary and may even be altered dynamically, that is to say, for example, as a function of settings altered by an operator.

Because use is made of a microprocessor system, the coordinate data of waveforms which are to be displayed and have been stored in the processor memory can easily be transmitted in a known way to the exterior of the oscilloscope, together with attribute information, in particular of measurement data.

Preferably, the processor system accepts a request to enable a DMA data transfer for the transfer of one or more data to the display memory with the highest priority. As a result of this, the FIFO display memory can nevertheless have a very small size in relation to preventing the occurrence of the said discontinuity in the display as a consequence of the display memory becoming empty.

Preferably, the DMA transfer from the processor memory takes place in burst mode. Because, as a result of this, the bus is occupied as expediently as possible during DMA transfer, this also prevents the occurrence of discontinuity in the display as a result of the FIFO display memory becoming empty.

If the method comprises the feature of claim 4, every first or second type word may contain two coordinates of an attribute information data dot at the same time or two data coordinates of two dots, to be displayed, of two respective waveforms. As a result of this, coordinate data for two waveforms can be transferred at the same time and therefore rapidly, the display of attribute information or of waveforms in the XY mode is facilitated and less data have consequently to be transferred per unit time to the display memory.

If the method comprises the feature of claim 7, the DMA transfer to the display memory can take place very rapidly in blocks, i.e. with as large blocks as possible of coordinate data of the same waveform or of a particular group of attribute information data. Nevertheless, during the display of a particular waveform, single coordinate data or groups of coordinate data of attribute information, for example relating to time cursors, can easily be inserted.

If the method comprises the feature of claim 9, the width of a waveform to be displayed can easily be altered. If a coordinate datum of a waveform dot is maintained longer, i.e. is supplied to the y-deflection means for a longer time after digital/analog conversion, said dot will be shown as a longer strip because an analog sweep signal having a fixed time base to the x-deflection means remains unaltered. At the same time, no more coordinate data of the waveform than necessary to produce the desired image need to be loaded into the FIFO display memory. Because, in this case, an x-deflection signal is not amplified in order to magnify a waveform, the image will not be troublesome if, as explained later, cursor dots or other information are displayed while the waveform is being displayed.

If the method comprises the feature of claim 10, the waveform dot having the coordinate data maintained for longer during the display is illuminated for a longer time. This can be used for more intensely illuminating a dot in the waveform where a trigger signal has occurred.

If the method comprises the feature of claim 11, a line pattern can be displayed during the maintenance time of the current level of the sweep signal which can be chosen at an arbitrary point in the sweep signal, under which circumstances the x-deflection signal is constant and a different y-coordinate datum is loaded into the FIFO display memory for every dot in the line pattern.

When the method according to claim 12 is used, a cursor having a chosen constant amplitude can thereby be displayed. As a result of this, amplitude or voltage cursors with a constant y-deflection signal or y-level or time cursors with a constant x-deflection signal can be displayed and the positions thereof are related to the physical screen.

If the method comprises the feature of claim 13, the oscilloscope can operate in an analog display mode with digitally generated cursors whose pattern of dots to be displayed are stored in the processor memory.

Preferably, coordinate data are transferred from the acquisition memory means to the processor memory by means of direct memory access (DMA) as described in claim 14. As a result of this, the control of the acquisition memory means is also facilitated both for the writing and for the reading thereof.

Once a waveform has been stored in the acquisition memory, it is not necessary for the coordinate data thereof to be transferred to the processor memory in the shortest possible time. The cycle steal mode is therefore preferably used for the DMA transfer to the processor memory.

If the feature of claim 16 is used, the display can take place in a simple way in the scan mode, in which a dot, to be displayed, of a most recently taken sample of an input signal travels from one side of the screen to the other and therefore circulates (generally from left to right).

If the method comprises the feature of claim 17, the display of a roll mode can be achieved in a simple way, in which a most recent sample is always displayed at the same time position on the screen, usually fully to the right, in general without a trigger signal being used.

The invention also provides an oscilloscope which is suitable for application of a method according to one of claims 1 to 17 inclusive.

It is observed that from GB-A-2 214 765 there is known a digital oscilloscope comprising a microprocessor system containing a bus structure and a processor memory. Samples of the wave form of an input signal are taken and digitized, each digitized sample corresponding to an amplitude of the input signal at the sampling time. A vector list of vectors between each pair of subsequent samples is determined and stored. The trajectory of each vector is a straight line from one pixel corresponding to a sample to another pixel corresponding to a subsequent sample with intermediate pixels if the length of the line is not zero. Thus, each vector to be displayed is represented by illuminating pixels having centre points bounding the trajectory of the vector on the screen. The intensity of each such illuminated pixel is modulated in accordance with a distance of its centre point from the vector trajectory. Said document does not relate to the prior art problems mentioned above and solved by the present invention.

Other characteristics and advantages of the invention will emerge from the explanation given below with reference to the attached drawings, wherein:

Figure 1a shows a left-hand section of a circuit diagram for an oscilloscope in which the invention is used;

Figure 1b shows a right-hand section of the diagram mentioned;

Figure 2 shows a time diagram of a sweep signal for an example of an operational sequence in applying the invention;

Figures 3a and 3b show steps in an operational program for the said operational sequence for a direct memory access (DMA) for data transfer from a processor memory to a display memory of the said diagram;

Figure 4 shows an example of a waveform with sample levels which are represented by heavy dots and which are represented by coordinate data in the circuit diagram;

Figures 5a to 5c inclusive each show, in the scan mode, an example of an image of the waveform of figure 4 for three consecutive repetitions of the image with refresh;

Figures 6a to 6c inclusive show diagrammatic memory areas of the processor memory in which the coordinate data of the imaged dots of the figures 5a to 5c inclusive have been stored;

Figures 7a to 7c inclusive each show, in roll mode, an example of an image of the waveform of figure 4 for three consecutive repetitions of the image with refresh; and

Figures 8a to 8c inclusive show diagrammatic memory areas of the processor memory in which the coordinate data of the imaged dots of the figures 7a to 7c have been stored.

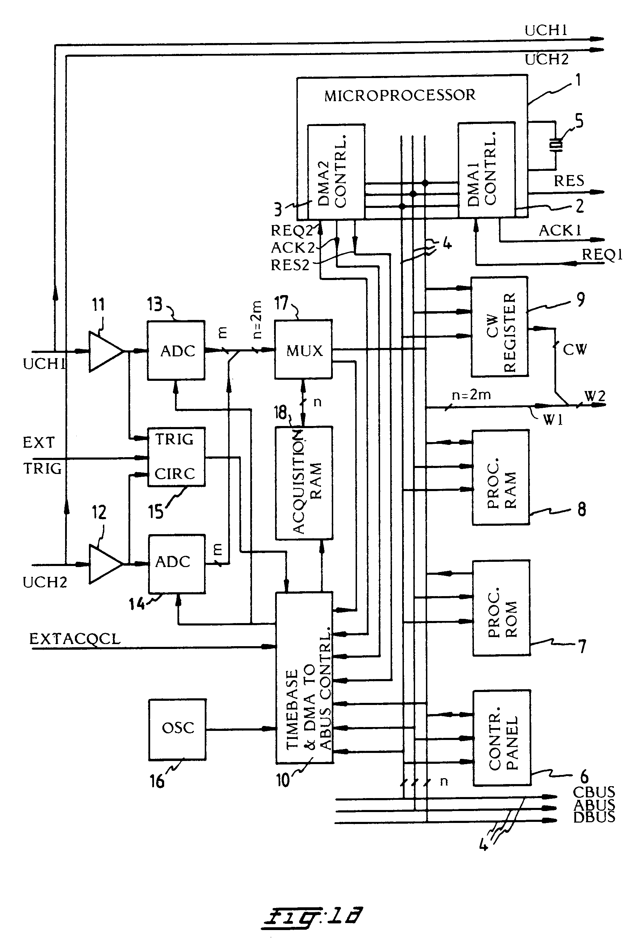

Figures 1a, 1b show, respectively, a left-hand section and a right-hand section of a circuit diagram for an oscilloscope in which the invention is applied. The heart of the diagram comprises a microprocessor system consisting of a microprocessor 1, a first direct memory access (DMA1) control 2 and a second direct memory access (DMA2) control 3 which are all connected to a bus structure 4 which consists of control bus CBUS, an address bus ABUS and a data bus DBUS. The microprocessor 1 and the DMA controls 2 and 3 may each be mounted in separate housings. All three may, however, also be mounted in a single housing. In an embodiment which has been constructed, a microprocessor of the type SCC68070 supplied by Philips was used with two DMA controls inside the same housing. A similar processor is the MC68340 supplied by Motorola. The two microprocessors mentioned last both have an external 16-bit data bus (DBUS). The external address bus (ABUS) of the SCC68070 is 23 bits and that of the MC68340 is 32 bits. The invention is not, however, limited to such a bus structure. In the explanation below, however, it is assumed that the data bus DBUS comprises $n = 2 \times m = 16$ bits.

Connected to the microprocessor 1 is a crystal 5 which determines the processing speed of steps of a program for the microprocessor. In the embodiment which has been constructed, the frequency of the crystal 5 was approximately 30 MHz.

Connected to the bus structure 4 are also an operating or control panel 6, a read-only processor memory (processor ROM) 7, a random access memory (processor RAM) 8, a control word (CW) register 9 and a time base and DMA to address bus control 10. The operating panel 6 and the control 10 comprise registers for buffering data therein. The processor ROM 7 is used in general for storing programs and program sections and values of variables which no longer alter after installation, while the processor RAM 8 is used in general for storing therein programs or program sections and values of variables which may alter after installation. As explained later, the processor RAM 8 contains, in particular, a display program to be dynamically altered by an oscilloscope user and coordinate data areas of waveform dots to be displayed and variable attribute information which may consist of cursors and text, for example of measured values. The registers mentioned earlier and the CW register 9, which can be loaded and/or read by the microprocessor 1 are generally known within microprocessor systems and are therefore not all shown separately and are not all explained separately. Other registers of this type connected to the microprocessor 1 are used, for example, to set particular components, explained below, of the circuit of figure 1.

The circuit is suitable for receiving two analog input signals UCH1 and UCH2 (on the left in figure 1a). The input signals UCH1 and UCH2 are supplied to a first amplifier/attenuator combination 11 and a second amplifier/attenuator combination 12, respectively. Outputs of the two amplifier/attenuator combinations 11 and 12 are connected to the analog inputs of a first analog/digital converter (ADC) 13 and a second analog/digital converter (ADC) 14, respectively, and both are connected to inputs of a trigger circuit 15 which also receives an external trigger signal EXTTRIG. In the realized embodiment the two analog/digital converters 13 and 14 are fast converters which convert each sample taken from an analog signal they receive into a digital signal of $m = 8$ bits. The analog/digital converters 13 and 14 receive a sampling clock signal from the time base and the control 10, which itself receives a clock signal from an oscillator 16 which, in the realized embodiment had a frequency of 40 MHz.

The two digital output words of the converters 13 and 14 are transferred in parallel, that it to say a total of $n = 2 \times m$ bits, to a random access acquisition memory (acquisition RAM) 18 via a multiplexer 17. The acquisition memory 18 is addressed by the control 10 during sampling of the input signals UCH1 and/or UCH2 and during acquisition of the digital words obtained in this process. The addressing of the acquisition memory and the writing therein of the digital words always continues cyclically until the control 10 receives a trigger signal from the trigger circuit 15, after which the control 10 still stores a predetermined number of digital words of samples taken in the acquisition memory. When this has happened, the contents of the acquisition memory 18 are, as explained later, transferred to a predetermined waveform area of the processor memory 8. Therefore said waveform area then contains coordinate data which represent the amplitude values or y-values of the samples taken and which can later be displayed with respect to a time base or x-axis. How this happens will be explained later. Because, after the occurrence of the trigger signal, a smaller number of samples or coordinate data can be taken than the entire waveform area can contain, later a section of the respective waveform can be shown which occurred before the occurrence of the trigger signal. The setting of the time base of the control 10, of the amplifier/attenuator combinations 11 and 12 and of the trigger circuit 15 can be carried out in the common way by means of the control panel 6 and via the microprocessor 1.

The waveforms which are obtained from the input signals UCH1 and UCH2 and stored and which consist of y-coordinate data are referred to below as waveforms CH1 and CH2, respectively, of a first and second display channel, respectively.

When the control 10 has stored the said predetermined number of samples in the acquisition memory 18 after the occurrence of the trigger signal, it delivers a request signal REQ2, which is a pulse, to the second DMA control 3. If possible, the microprocessor 1 will then make the bus structure 4 available to the DMA2 control 3. If this happens, the DMA2 control 3 delivers an acknowledgement signal ACK2, which is a pulse, to the control 10 which then controls the multiplexer 17 and the acquisition memory 18 in order to deliver the contents of the first location of the acquisition memory 18 which follows the last location which has been written into after the occurrence of the trigger signal to the data bus DBUS. The DMA2 control 3 then places the word obtained from the acquisition memory 18 in a first location of a predetermined waveform area in the RAM processor memory 8. The DMA2 control 3 then increments a counter thereof by 1 and the control 10 increments an address counter thereof by 1 in order to point to the next location in the acquisition memory 18. The control 10 then again delivers a request signal REQ2 in order to transfer a subsequent word from the next location from the acquisition memory 18 to the RAM process memory 8. This continues until the DMA2 control 3 has counted a predetermined number of transfers. The DMA2 control 3 then delivers a reset signal RES2 to the control 10 which stops the delivery of request signals REQ2 and which may then start a new acquisition of the input signals UCH1 and UCH2. The predetermined number of transfers after which the DMA control 3 delivers the reset signal RES2 is determined by a program for the microprocessor and is placed in a register of the DMA2 control 3. Such a DMA transfer with one word at the same time is known as a cycle steal mode DMA. Such a DMA transfer and such a use of counters for the transfer are known per se and figure 1a therefore shows no details thereof. In the realized embodiment the DMA2 transfer of data can take place at a speed of 10K words per image refresh time, which is more than adequate with an acquisition time of 4K words per image refresh time for two input signals UCH1 and UCH2 at the same time.

After the transfer by means of the DMA2 control 3, the RAM processor memory 8 contains a waveform area, each location of which contains two coordinate data, one datum for each of the input signals UCH1 and UCH2. When these locations are read out, the coordinate data of the two waveforms of the two input signals UCH1 and UCH2, respectively, therefore become available again at the same time, as a result of which the number of transfers necessary for an XY display mode is halved, while by the same limited number of transfers at any instant there can be chosen for displaying one of the waveforms in a Yt display mode. This will be explained further later.

Of the said waveform area in the RAM processor memory 8, it can also be said that it consists of two waveform areas or waveform subareas, depending on which display mode is desired.

In addition to the said area containing the waveforms of the input signals UCH1 and UCH2, the RAM processor memory 8 may also contain another such area which stores two reference waveforms REF1 and REF2 which can be loaded directly from the acquisition memory 18 or from the area containing the waveforms for the input signals UCH1 and UCH2.

In addition, the RAM processor memory 8 may contain other waveform areas containing processed waveforms of the input signals UCH1 and UCH2 and of the reference waveforms REF1 and REF2 and further reference waveforms. Application of the microprocessor system makes any number of areas of any type of waveforms possible and said waveforms can be displayed in any desired combination or sequence without the hardware of the circuit for the oscilloscope according to the invention having to be altered. It is sufficient for the processor memory 7, 8 to be sufficiently large, the program for the microprocessor 1 to be adapted and any settingsfor this purpose to be made from the control panel 6.

The control word (CW) register 9 is destined for storing a control word CW therein which indicates a control function. As explained later, during the display of any dot on the screen of the cathode ray tube of the oscilloscope, an individually assigned control word CW is present which, together with one or two coordinate data, is read out of the processor memory 7, 8. The word read out of the processor memory 7, 8 and containing two coordinate data is referred to as a first type word W1. The combination of the first type word W1 and the associated control word CW is referred to as second type word W2. The control word CW can comprise any suitable number of bits. In the realized embodiment the size of the control word CW was 1 byte = 8 bits. The table given below gives a number of values of the control word CW and the associated display functions in the embodiment which has been produced.

## TABLE

| Control word binary | hex | Display function |
|---|---|---|
| 00010010 | 12 | screen related Y (voltage) cursor 1, burst mode |
| 00010011 | 13 | screen related Y (voltage) cursor 2, burst mode |
| 00011010 | 1A | screen related Y (voltage) cursor 1, chop mode |
| 00011011 | 1B | screen related Y (voltage) cursor 2, chop mode |
| 00100010 | 22 | screen related X (time) cursor 1, burst mode |
| 00100011 | 23 | screen related X (time) cursor 2, burst |

```
                mode

00101010   2A    screen  related  X  (time)  cursor  1,  chop
                mode
00101011   2B    screen  related  X  (time)  cursor  2,  chop
                mode


00110000   30    burst mode blanked text
00110010   32    burst mode text
00111000   38    chop mode text

00110100   34    burst mode stored input waveforms XY
                display
00110110   36    burst mode stored reference waveforms XY
                display


10000000   80    waveform related X (time) cursor

10001000   88    long triggerpoint channel 2 stored
                reference waveform
10011000   98    long triggerpoint channel 2 stored input
                waveform
10101000   A8    long triggerpoint channel 1 stored
                reference waveform
10111000   B8    long triggerpoint channel 1 stored input
                waveform
11000000   C0    channel 2 stored reference waveform,
                blanked, unmagnified
11000011   C3    channel 2 stored reference waveform, x50
                magnified
11000100   C4    channel 2 stored reference waveform,
                unmagnified .
11001101   CD    channel 2 stored reference waveform, x10
                magnified


11010000   D0    channel 2 stored input waveform, blanked,
                unmagnified
11010011   D3    channel 2 stored input waveform, x50
                magnified
11010100   D4    channel 2 stored input waveform,
                unmagnified
11011101   DD    channel 2 stored input waveform, x10
                magnified


11100000   E0    channel 1 stored reference waveform,
                blanked, unmagnified
11100011   E3    channel 1 stored reference waveform, x50
                magnified
11100100   E4    channel 1 stored reference waveform,
                unmagnified
11101101   ED    channel 1 stored reference waveform, x10
                magnified


11110000   F0    channel 1 stored input waveform, blanked,
                unmagnified
11110011   F3    channel 1 stored input waveform, x50
                magnified
11110100   F4    channel 1 stored input waveform,
                unmagnified
```

```
11111101   FD    channel 1 stored input waveform, x10
                 magnified
```

Second type words W2 of dots to be displayed on the screen of the cathode ray tube are, as explained later, transferred to a first-in-first-out (FIFO) display memory 30 (on the left in figure 1b) under the control of the first direct memory access (DMA1) control 2. The FIFO display memory 30 has a number of locations which can each contain at least one second type word W2. The number of locations of the FIFO display memory 30 may, as explained later, be limited. In the realized embodiment the FIFO display memory 30 had a capacity of 16 locations each containing 24 bits.

Before an image having a desired composition can be displayed on the screen, the microprocessor 1 assembles a program which depends on the settings made with the control panel 6 and the sequence of waveform and attribute information dots to be displayed. During the display of the image, said program is processed by the microprocessor 1 and always repeated or replaced by another similar program in which, for example, new settings have been incorporated, so that it can be said that the microprocessor 1 processes a dynamically variable display program.

The second type words W2, consisting of two coordinate data and the associated control word CW, are shifted at a specified speed out of the FIFO display memory 30. This speed is determined by an oscillator 31 and a first state machine 32 which comprises several counters for dividing the clock signal originating from the oscillator 31. At particular instants, which are determined by the clock frequency of the oscillator 31 and the counters of the first state machine 32, the first state machine 32 delivers a control signal to a second state machine 33 which then delivers a shift-out pulse SOUT to the FIFO display memory 30, as a result of which the first second-type word W2 placed in the display memory 30 is shifted out. Of the second-type word W2 shifted out of the display memory 30, the control word CW is delivered to the first state machine 32, a first half of the first-type word W1 of the second-type word W2 is delivered to a fast digital/analog convertor (DAC) 34 and the other half of the said first-type word W1 is delivered to another fast digital/analog convertor (DAC) 35.

When the FIFO display memory 30 is almost full - the second state machine 33 keeps track of this by counting W2 shift-in pulses SIN (explained below) and W2 shift-out pulses SOUT - the second state machine 33 delivers a request signal REQ1 having a first level to the first DMA1 control 2. As long as the request signal REQ1 has the first level, the first DMA1 control 2 will not perform any DMA transfers from the processor memory 7, 8 to the FIFO display memory 30. On the other hand, if the FIFO display memory 30 is not almost completely full, the second state machine 33 sets the request signal REQ1 to a second level, as a result of which the first DMA control interrupts the operation of a program for the microprocessor 1 with the highest priority and takes over the management of the bus structure 4. The DMA1 control 2 can then transfer, as explained later, first-type words W1 containing coordinate data to the FIFO display memory 30 from the processor memory 7, 8 by means of DMA, together with the control word CW from the CW register 9. As soon as a second type word W2 is available on data inputs of the FIFO display memory 30 under these circumstances, the DMA1 control 2 delivers an acknowledgment pulse ACK1 to the second state machine 33 which then delivers a shift-in pulse SIN to the FIFO display memory 30 for shifting the second type word W2 into the display memory 30. The method of DMA transfer used here is burst mode DMA transfer. In the realized embodiment this transfer can take place at a speed of 2,4 M words per second, which is more than adequate with an image refresh time of 20 ms and less than 20 K image dots per image.

When the contents of the FIFO display memory 30 have to be erased, for example when the display of an image is started, the processor 1 delivers a reset signal RES to the FIFO display memory 30 and to state machines 31 and 33.

Depending on the control word CW received by the first state machine 32, the latter delivers a number of control signals, including the already mentioned control signal, to the second state machine 33, a modulation signal UZ to a Z-modulator (not shown) to modulate the intensity of an electron beam of the oscilloscope, addresses to a first multiplexer 40, a second multiplexer 41, a third multiplexer 42, and a fourth multiplexer 43, as well as a control signal to an electronic switch 44, and a hold signal HOLD and a reset signal RESSW to an analog sweep generator 45.

If the analog sweep generator 45 is not reset by the reset signal RESSW, it delivers an analog sawtooth sweep voltage having a fixed slope to one of the analog inputs of the multiplexer 41. If the analog sweep generator 45 receives the hold signal HOLD during the generation of the sweep signal, the level of the sweep signal is maintained at the level at the instant when the hold signal HOLD was received. The sweep signal then has a constant component as a function of time which can be referred to in English as "dwell".

Other analog inputs of the first and the second multiplexers 40, 41 receive analog signals from the first and second digital/analog converters 34, 35 and from a slow 12-bit digital/analog converter and analog hold circuit 46 which receives, depending on the settings made with the operating panel 6, digital words through the microprocessor 1 via the bus structure 4, which words are converted into analog signals, some of which, for example UF1 and UF2 are retained and delivered to the multiplexers 40 and 41.

The analog output of the multiplexer 40 is connected to an analog input of the multiplexer 42 via an analog adder 47. The analog output of the multiplexer 41 is connected to an analog input of the multiplexer 43. If the control signal to the electronic switch 44 has a certain level, the latter passes a reference displacement signal URS to the adder 47, as a result of which the signal URS is added to the output signal of the multiplexer 40 and the sum is delivered to the multiplexer 42. Although not shown, the displacement voltage URS originates from a voltage source which can be adjusted from the control panel 6 and via a program for the microprocessor 1. The addition of the displacement voltage URS can be used, in particular, for displacing a displayed reference waveform vertically.

At other analog inputs, the third and fourth multiplexers 42 and 43 receive the analog input signals UCH1 and UCH2 and a sweep signal (having a sawtooth form) originating from an analog sweep generator 48. The duration of the sweep of the sweep generator 48 can be adjusted from the operating panel 6 via the microprocessor 1 and the bus structure 4.

The multiplexers 42 and 43 deliver output signals UX and UY, respectively, to deflection means (not shown) for deflecting the electron beam of the cathode ray tube.

If the oscilloscope is set to a digital mode, the multiplexers 42 and 43 are set to pass the output signals of the adder 47 and the multiplexer 41.

If the oscilloscope is set to an analog mode, the multiplexer 42 is set to pass the analog input signal UCH1 or UCH2 and the multiplexer 43 can be set to pass the analog input signal UCH2 (for XY display mode) or to pass the sweep signal SWPAM from the sweep generator 48. Because the multiplexer 43 has one analog input more than the multiplexer 42, the multiplexer 43 receives an additional signal for addressing the multiplexer 43 from the sweep generator 48.

If the oscilloscope is in the analog display mode, it is nevertheless possible that the multiplexers 42 and 43 are temporarily set to the digital display mode at predetermined instants in particular so as to display attribute information, such as X (time) and Y (voltage) cursors which, as regards their position, do not have any relationship to the position of the waveforms of the analog input signals UCH1 and/or UCH2 but have a relationship to the position of the physical screen.

In the realized embodiment the frequency of the oscillator 31 was 5 MHz. Depending on the programming of the counters of the first state machine 32 by means of the control word CW, second type words W2 of coordinate data of waveforms were read then at a speed of 1 µs out of the FIFO display memory 30 and second-type words W2 of coordinate data of attribute information were read out at a speed of 2,2 µs. If not magnified, the waveform dots were therefore displayed at a time interval of 1 µs and the attribute information dots at a time interval of 2,2 µs. Because of transition phenomena, in particular due to the operation of the digital/analog convertors 34 and 35, the electron beam is blanked for 0,2 µs of the 1 µs mentioned during the display of a dot of a waveform. For attribute information image dots, the electron beam is blanked for 1,2 µs of the 2,2 µs, as a result of which the electron beam has adequate time to be deflected to any subsequent dot on the screen and the image dots are not connected to one another.

In a mode which has been chosen by means of the control word CW and in which an imaged waveform has to be displayed in magnified form, only the coordinates of image dots of the waveform which are actually displayed are loaded into the FIFO display memory 30 and the first state machine 32 divides the frequency received from the oscillator 31 so as to delay the reading-out of the FIFO display memory 30. Because the slope of the sweep signal SWPDM from the analog sweep generator 45 is constant, the limited number of dots of the waveform will then be displayed regularly over the width of the screen, the image dots being altered to form strips having a constant (Y-) amplitude. This method of magnifying the display of waveforms is therefore completely different from that used in the prior art, in which the X-deflection signal was simply amplified and repositioned using a displacement voltage. The advantage of the magnification method according to the invention is that the accuracy and the quality of the image remains ideal; with simple amplification of the X-deflection signal, inaccuracies and interferences would also be amplified. In addition, with the magnification according to the invention, more magnification factors can be used within a waveform to magnify sections of the waveform to a greater or lesser extent, and, in addition, this can easily be achieved by means of software.

To explain the state machines 32 and 33, it may be stated that a state machine, as known per se, selects a combination of a number of possible combinations of values or amplitudes of output signals depending on the values or amplitudes of a number of input signals. The relationships between values of groups of input signals and of the associated combinations of values of output signals can be determined and set by designers. Because this is a technique which is known per se, it is not considered necessary to reveal the embodiments of the state machines 32 and 33 in detail in the figures and to explain them by reference thereto. However, it can be stated that in the realized embodiment the first state machine 32 consisted of a programmable type 22V10 integrated circuit supplied, for example, by Cypress which, although it comprised a number of flipflops by which a counting function could be achieved, an additional counter was added thereto to increase the counting facilities. In the embodiment which has been constructed, the second state machine 33 consisted of a programmable type 16V8 integrated circuit supplied, for example, by Cypress.

In the realized embodiment the FIFO display memory 30 having 16 locations containing 24 bits each consisted of six type 74HCT40105 integrated circuits supplied, for example, by Philips each containing 16 memory locations of 4 bits each.

The realized embodiment has been designed such that a waveform is redisplayed on the screen of the cathode ray tube at least 50 times per second, that is to say with a refresh time of 20 ms, possibly by means of an altered display program which can be adjusted during the display of a previous display of the waveform, for example on the basis of settings altered with the control panel 6.

The structure of the circuit shown in figures 1a and 1b is such that four different waveforms, namely the waveforms CH1 and CH2 obtained by sampling the input signals UCH1 and UCH2, and two stored reference waveforms REF1 and REF2, which may each have been obtained from earlier waveforms CH1 and CH2, can be displayed every 20 ms. The display of the different waveforms is alternated with the display of attribute information. As explained later, attribute information, in particular a trigger dot and waveform-related time cursors can also be displayed during the display of any waveform. In the embodiment which has been constructed, the size of any waveform had a maximum of 4096 image dots, and with a read-out speed of the FIFO display memory 30 of 1 μs per image dot, this determines a duration of 4096 μs, or approximately 4 ms, for the duration of a sweep or a sawtooth of the sweep signal SWPDM. Of the desired minimum refresh time of 20 ms mentioned, 3616 μs are then left over for displaying attribute information. Within this time, more than 1600 image dots of the attribute information can be displayed, and in practice this is more than adequate.

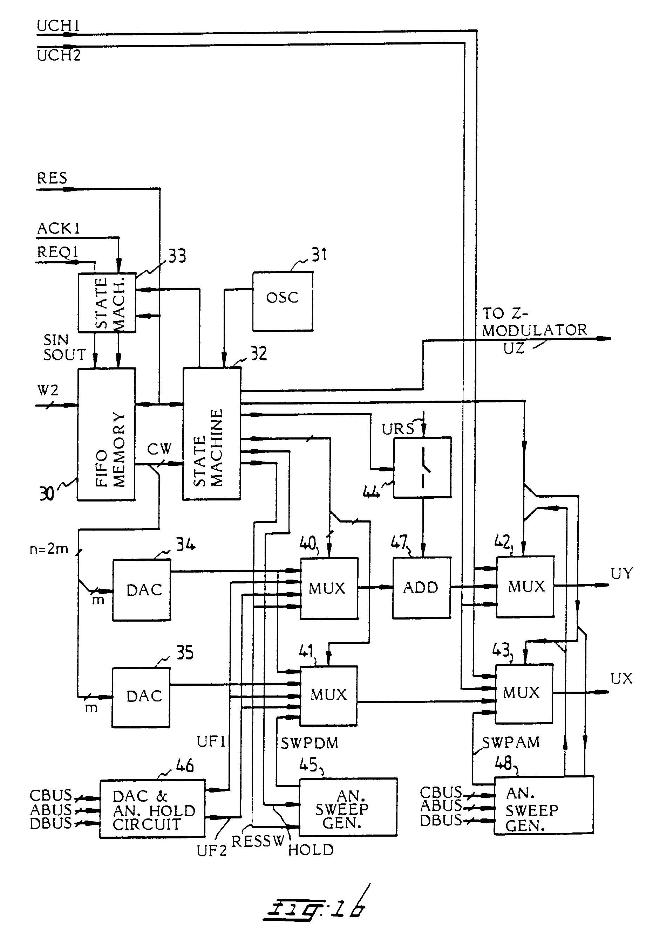

Figure 2 shows a time diagram of the sweep signal SWPDM for displaying the four waveforms mentioned, in which a trigger dot is illuminated longer and a waveform-related time cursor 1 is displayed during the display of the stored waveform CH1, a second waveform-related time cursor 2 is displayed during the display of the waveform CH2, and other attribute information is displayed between the four respective sweeps during a reset time of the sweep signals SWPDM.

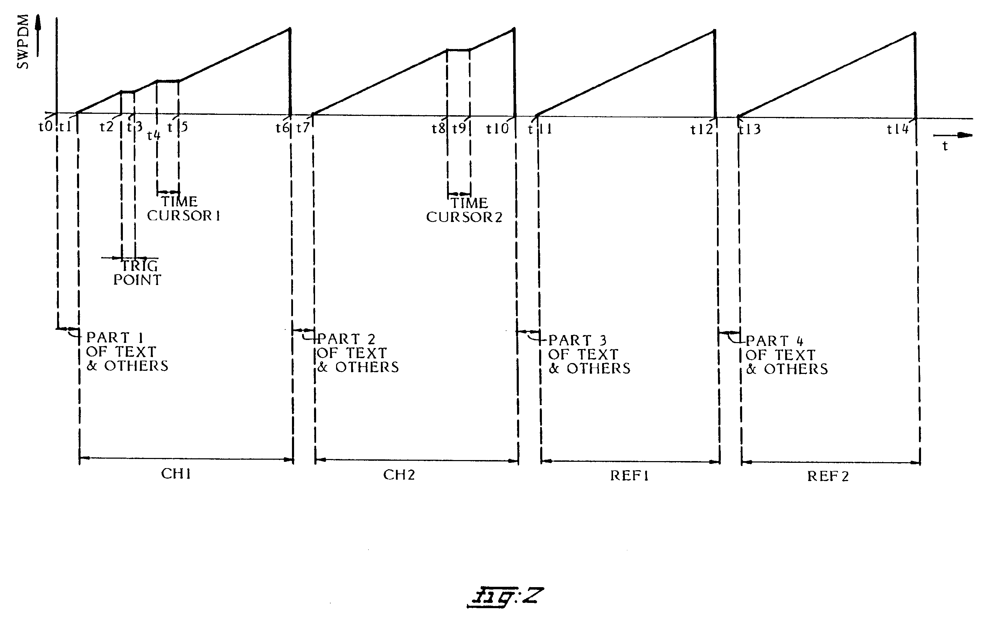

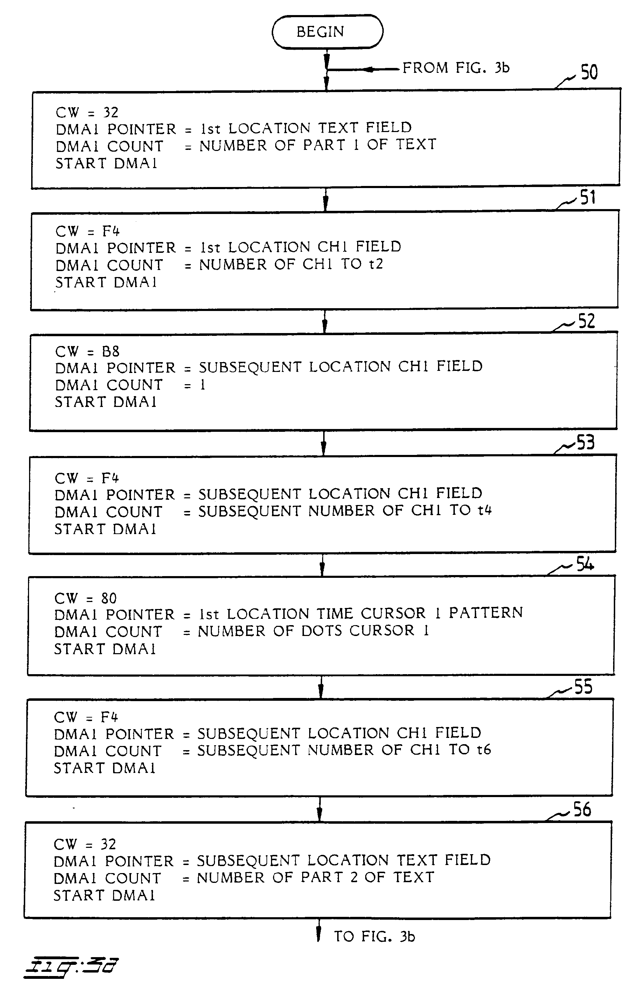

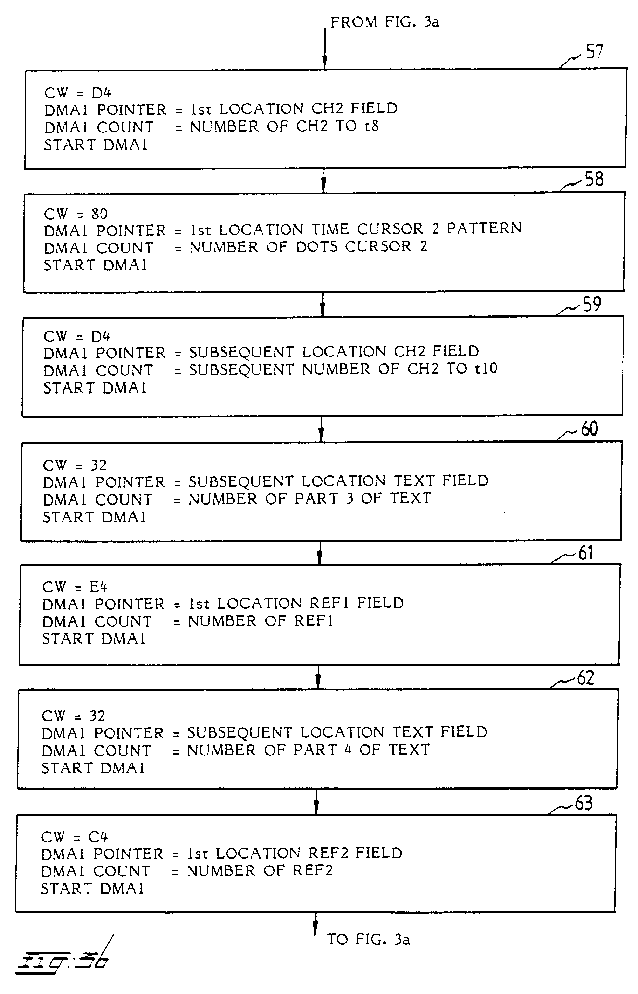

Figures 3a and 3b show a diagram of a display program for the microprocessor 1 which is stored in the RAM processor memory 8. The diagram of figures 3a and 3b comprises 14 blocks each containing 4 instructions for loading the control word register 9, setting the first DMA1 control 2 and starting the DMA1 control. The 14 blocks relate respectively to the 14 display intervals between t0 to t14 inclusive of figure 2. However, it is not a requirement that the microprocessor 1 starts by executing the respective blocks at the instant of the respective interval. In other words, the instants t1 to t14 inclusive are not fixed.

According to a first block 50 of the diagram of figure 3a, from the current display program the microprocessor 1 writes a control word CW having hexadecimal value 32 into the control word register 9, and makes the DMA1 pointer of the DMA1 control 2 equal to the address of the first location of an attribute information area, which area will be referred to below as text area, in order to indicate that a group of coordinate data relating to attribute information must be transferred to the FIFO display memory. The microprocessor 1 furthermore makes the DMA1 block size or count equal to the number of coordinate data or dots to be displayed of a first section of the text area. The microprocessor then starts the DMA1 control 2, after which the latter transfers the first section of the text area mentioned to the FIFO display memory 30 by means of burst mode DMA. As stated above, under these conditions second type words W2 will be loaded into the FIFO display memory 30 as long as the request signal REQ1 is at its second level and, after receipt of an acknowledgement pulse ACK1 by the second state machine 33, each second-type word W2 is actually loaded into the FIFO display memory 30 by means of a shift-in pulse SIN.

After the first section of the text area defined in block 50 of figure 3a has been transferred to the FIFO display memory 30, the DMA1 control 2 communicates this to the microprocessor 1 by means of an interrupt signal. In response thereto, the display program will proceed with block 51 shown in figure 3a. According to program block 51, the microprocessor 1 loads a control word CW having value F4 into the control word register 9 in order to indicate that the subsequent group of waveform coordinate data to be transferred to the FIFO display memory 30 are of the first channel CH1. Furthermore, the microprocessor sets the DMA1 pointer to the address of the first location of the CH1 area of the processor memory 8. The microprocessor 1 furthermore sets the DMA1 block size to the number of data coordinates of channel CH1 dots which have to be displayed in an interval t1-t2. The microprocessor 1 then starts the DMA1 transfer of the area defined in this way to the FIFO display memory 30.

After the group of coordinate data defined in block 51 of figure 3a has been transferred, the DMA1 control 2 communicates this again to the microprocessor 1, which then starts to process the subsequent block 52 of figure 3a. According to block 52, the microprocessor 1 loads a control word CW having value B8 into the control word register 9, sets the DMA1 pointer to the address of the subsequent location of the CH1 area which has not yet been transferred to the FIFO display memory 30 and sets the DMA1 block size to one. The microprocessor 1 then starts the DMA1 transfer. When the first state machine 32 receives the control word CW having the value B8, it delivers the hold signal HOLD to the sweep generator 45 so as to maintain the level of the sweep signal SWPDM during a time interval t2-t3. During this time, the image dot concerned is therefore illuminated longer than other dots, and this can be used to show a trigger dot intensified. Block 52 of the diagram in figure 3a has then been completed.

The display program then proceeds with the subsequent block 53 of the diagram of figure 3a, which relates to the group of coordinate data of CH1 area dots to be displayed in the time interval t3-t4 excluding the datum transferred according to block 52.

The display program then proceeds with block 54 of figure 3a. The microprocessor 1 then loads a control word CW with value 80 into the control word register 9, sets the DMA1 pointer to the address of the first location of a cursor 1 pattern which may be stored in the ROM processor memory 7, sets the DMA1 block size to the number of cursor 1 pattern dots to be displayed and starts the DMA1 transfer. When the first state machine receives the control word CW having the value 80, it will deliver the hold signal HOLD to the analog sweep generator 45, and as a result of this the level of the sweep signal SWPDM is maintained so as to image a dot having a y-coordinate datum which, together with the control word CW having the value 80, is shifted out of the FIFO display memory 30. The first state machine 32 will receive a control word having value 80 for each of the cursor 1 pattern dots to be displayed, so that the level of the sweep signal SWPDM will be maintained during the display of the entire cursor 1 pattern.

The display program then proceeds with block 55 of figure 3a. Block 55 defines a group of CH1 area coordinate data, to be transferred, of dots to be displayed which occur in the time interval t5-t6.

The display program then proceeds with block 56 of figure 3a, which is of the same type as block 50, so as to display a second section of the attribute information.

The display program then proceeds with block 57 of figure 3b so as to display CH2 waveform image dots which occur in the time interval between the instants t7-t8 of the second sweep within the image refresh time of 20 ms.

The display program then proceeds with block 58 for displaying a second X or time cursor 2 in the time interval t8-t9 in the way explained with reference to block 54 for displaying the time cursor 1. The time cursors 1 and 2 may have different patterns.

The display program then proceeds with block 59 of figure 3b so as to display CH2 waveform dots in the interval t9-t10.

The display program then proceeds with block 60 of figure 3b so as to display the third section of the text area in the way explained with reference to block 50 of figure 3a.

The display program then proceeds with block 61 of figure 3b so as to display the REF1 waveform.

The display program then proceeds with block 62 of figure 3b so as to display the fourth section of the text area in the way explained with reference to block 50.

The display program then proceeds with block 63 of figure 3b so as to display the REF2 waveform, which is the last waveform to be displayed within an image refresh time of 20 ms.

The display program then returns to block 50 at the start of the display program. If, in the meantime, an image having another composition is desired, it is possible to jump, as an alternative, to the start of another display program which has been assembled in the meantime by the microprocessor 1 during the relatively long time that the bus structure was not in use for DMA1 or DMA2 transfers.

Because the positions of the X or time cursors 1 and 2, as explained with reference to the blocks 54 and 58 of the diagram of figures 3a and 3b for the display program, are related to the level (not equal to 0) that the sweep signal SWPDM has at that instant, the positions of said time cursors 1 and 2 are related to the position of the waveforms shown and not to the physical screen or a scale division thereof.

As can be read in the table, other cursors can be displayed whose position is indeed related to the physical screen or the scale division thereof. For these cursors, the second-type words W2 each comprise an x-coordinate data and a y-coordinate data for each cursor dot to be displayed. As a result, the position of such an image point has no relationship to the position of one of the waveforms shown.

The screen-related cursors can all be used in the analog mode of the oscilloscope. If the time base or analog sweep generator 48 is then set to a short sweep time, in which case many images can be refreshed per unit time, display of screen-related cursors in burst mode can be chosen. In this case, the cursor is imaged in one go. For longer sweep times than, for example, 2 ms, the screen-related cursors are preferably displayed in chop mode. In that case, the display of an image dot or some image dots of the cursor concerned is alternated with the display of the analog signals UCH1 and/or UCH2.

The screen-related cursors can also be used in the digital mode of the oscilloscope. Because the display speed, or sweep time of the sweep signal SWPDM of the sweep generator 45 is, however, constant and relatively short and, in the digital mode, waveform-related cursors can also be displayed, in the realized embodiment in the digital mode of the screen-related cursors only the cursors having hexadecimal values 12 and 13 are used.

However, all the cursors can be displayed in parts distributed in time, that is to say displaying between the parts thereof whole or partial waveforms.

The control words CW having hexadecimal values C0, D0, E0 and F0 are used in order not to show a section of the waveform concerned. This may be useful in positioning the waveforms shown on the screen.

The control word CW having hexadecimal value 30 is used to generate an interval during the display in which the electron beam is blanked. This may be useful if the interval between two consecutive dots to be displayed on the screen is relatively large, so that during said interval, or a series of such intervals, the electron beam has time to be displaced over said interval without the displacement being visible. This may be used, inter alia, during the flyback of the beam at the end of a sweep.

The attribute information can, as explained with reference to the figures 2, 3a and 3b, be displayed with bursts of coordinate data of the attribute information dots to be displayed, the control word CW having the hexadecimal value 32, or spread over the image refresh time of 20 ms, in which case the control word CW has the value 38.

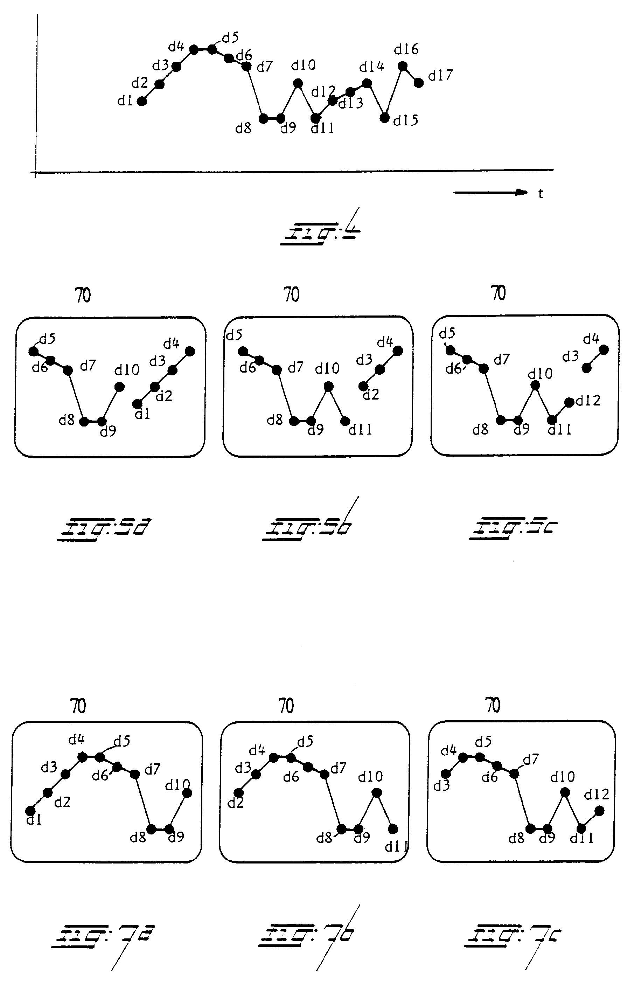

An important aspect of the invention is furthermore that waveforms stored in a simple manner, of which new samples are continuously taken, can be displayed on the screen in a scan mode of roll mode. This will be explained with reference to figures 4 to 8 inclusive. In this connection, it is assumed that always ten dots of a waveform can be displayed during a sweep of the sweep signal SWPDM and that the refresh time corresponds to the time for displaying a single waveform and attribute information and that during the refresh time one sample is taken.

Figure 4 shows an example of an input signal UCH1 or UCH2 as a function of the time t, in which figure samples d1 to d17 inclusive taken and to be taken are indicated by heavy dots. It is assumed that the sample d10 is the last sample taken, that is to say the samples d1 to d9 inclusive have already been taken.

If, as stated, the sample d10 is the last sample taken, the waveform shown in figure 5a is shown in the scan mode on the screen 70 of the oscilloscope. Although, as explained above, the electron beam is blanked during displacement from one image dot to the next image dot, connections are shown between consecutively shown image dots in figure 5a for the sake of clarity and for easier comparison with figure 4. Between the last sample d10 taken and the first sample d1 taken of the samples d1 to d10 inclusive of the samples shown, no connection is shown because those dots are the start and the finish, respectively, of the actual section of the waveform. This method of representation is also used for figures 5b, 5c and 7a to 7c inclusive which will be explained below.

When the image is refreshed, that is to say during the occurrence of the subsequent sweep of the sweep signal SWPDM, a subsequent sample d11 will have been taken and this will replace the sample d1 in the image. During yet another subsequent sweep, the sample d2 will be replaced by the sample d12, and so on.

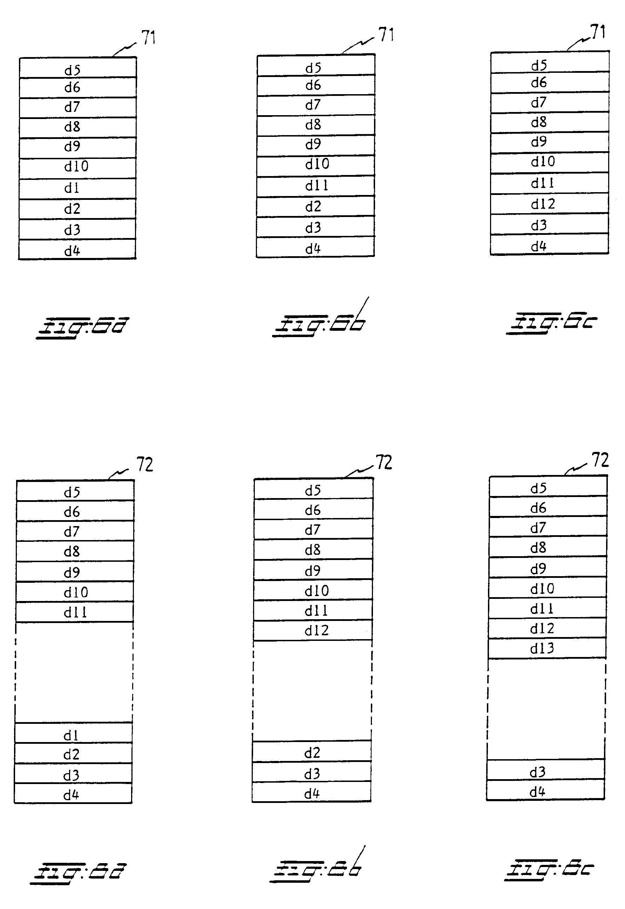

For the scan mode, figure 6a to 6c inclusive diagrammatically show waveform areas 71 in the RAM waveform memory 8, the consecutive locations of which being filled with values of the samples of waveforms shown in figures 5a to 5c inclusive, respectively. Whenever a sample is taken, the DMA2 control 3 writes it as quickly as possible into the waveform area 71 at a location containing the oldest sample. As a result of this, consecutive samples are written into consecutive locations of the waveform area 71. While the samples are being displayed, the display program always sets the DMA1 pointer of the DMA1 control 2 to the first address of the waveform area 71, as a result of which the display of the contents of the waveform area 71 always starts from the sample d5 as shown in figure 6a to 6c inclusive. When two sweeps are over after the sweep for showing the image of figure 5c, the sample d5 in the first location of the waveform area 71 is replaced in the subsequent sweep by the sample d15, and so on.

In the roll mode, and if the sample d10 is again the last sample taken, the ten last samples taken will be shown on the screen 70 in the way shown in figure 7a, that is to say with the most recent sample d10 fully to the right. While the image of figure 7a is being shown, a new sample d11 will be taken which will be shown instead of the sample d10 as last sample during a subsequent sweep of the sweep signal SWPDM, the nine previously taken samples d2 to d10 inclusive being shown earlier in this order during the sweep and the sample d1 disappearing from the screen. As a result, the waveform shown in figure 7a will move to the left on the screen 70, the waveform always being supplemented with a new sample, in figure 7c the sample d12, on the right of the screen 70 and other samples on the left of the screen 70 disappearing.

In the roll mode, the samples taken are written into a waveform field 72 in the same way as in the scan mode. However, during the display, the display program for the microprocessor 1 sets the DMA2 pointer to an address which is increased by one for each sweep. Furthermore, the display program makes the DMA2 block size of the number of coordinate data, to be transferred to the FIFO display memory 30, of waveform dots to be displayed as large as possible and then possibly carries out a DMA transfer of a subsequent block from the start of the area 72 in order that the coordinate data of all the dots to be displayed are transferred. To show the image of 7a, the DMA2 transfer will then have to take place in two steps. In the first step, the display program sets the pointer to the address containing the sample d1 and makes the DMA block size equal to four, namely for shwoing the last four samples d1 to d4 inclusive which are stored in the memory field 72. In the next step, the display program sets the DMA2 pointer to the address of the first location of the waveform area 72 and makes the DMA2 block size equal to the number of dots which, of the total number of image dots, still have to be transferred to complete the image. During said second step, the DMA2 block size will therefore be six in order to show the samples d5 to d10 inclusive.

Figures 8b and 8c show the waveform area 72 during the display of the images shown in figures 7b and 7c, respectively.

In the realized embodiment in the scan mode and in the roll mode a sample is taken every 250 µs and stored as quickly as possible in the processor memory 8 by means of the DMA2 control 3. In the scan mode, in each image of a waveform 80 samples of the previous image will be replaced then for the refresh time of 20 ms for four waveforms. In the roll mode also 80 samples will again be taken in the said refresh time of 20 ms. In the realized embodiment, the waveform area 72 will therefore have to have at least 80 locations more in the roll mode than the number of waveform dots which are shown. Under certain conditions, for example during acquisition by means of an external acquisition clock signal (EXTACQCL), the acquisition interval may be shorter than 250 µs. During the image refresh time of 20 ms, more than 80 samples are taken then. In the realized embodiment a reserve of 200 locations instead of 80 is therefore used for the waveform area 72.

As explained above, the invention provides a method for displaying waveform information and attribute information which can be implemented in a simple way, it being easily possible to alter a desired composition of an image by programming without the need of complicated hardware or alteration of the latter. In contrast to the known method mentioned, with the method according to the invention always a stable, interference-free image can be shown. In addition, if the method according to the invention is used, all the coordinate data stored in the processor memory can be transferred out of the oscilloscope without the need of complicated control means specifically destined for this purpose. For such a transfer, it is possible to manage, for example, with a UART ("Universal Asynchronous Receiver Transmitter"). The microprocessors mentioned, SCC68070 and MC68340, even have an inbuilt UART (not shown) and this makes the implementation still simpler.

## Claims

1. Method for displaying a waveform (CH1, CH2, REF1, REF2) of at least one input signal (UCH1, UCH2) and attribute information on a screen of a cathode ray tube of an oscilloscope, comprising obtaining coordinate data, which each represent a coordinate of a sample dot to be displayed of the waveform, or of a dot of the attribute information, storing the coordinate data of each dot in an acquisition memory means (18), transferring the dot coordinate data from the acquisition memory means (18) to display memory means (30), storing the dot coordinate data in the display memory means (30), reading the dot coordinate data out of the display memory means (30) at a predetermined speed and in a predetermined sequence, converting each dot coordinate datum read into a first analog deflection signal (UX), generating a second analog deflection signal (UY), which may be a sweep signal (SWPDM), selecting said first and second deflection signals, one of which is the sweep signal during the display of a waveform in a signal amplitude to time (Yt) display mode, and delivering the selected deflection signals (UX, UY) to deflection means for the cathode ray tube so as to deflect the electron beam thereof to a position on the screen whose coordinates are determined by the selected deflection signals, the intensity of the beam in the selected position being modulated as a function of a modulation signal (UZ), characterised in that all the coordinate data are stored in a processor memory (7,8) which is connected to a bus structure (4) of a microprocessor system, a display program is assembled for the microprocessor system, which display program depends on a desired composition of an image on the screen and a desired display sequence of the image dots, the display program is stored in the processor memory (7,8), the display program selects, during the operation thereof, coordinate data of dots to be displayed from the processor memory (7,8), each selected coordinate datum is transferred by means of direct memory access (DMA1) from the processor memory (7,8) to a first-in-first-out (FIFO) display memory (30), the display program determines for each selected coordinate datum a display control datum (CW) and transfers it at the same time as a coordinate datum to the display memory (30), the transfer to the display memory (30) is continuously repeated but postponed if, and for as long as, the display memory (30) has reached a predetermined degree of occupation, and each control datum (CW) is read out of the display memory (30) together with a coordinate datum determining the selection of the deflection signals and the modulation signal (UZ).

2. Method according to claim 1, characterised in that the processor system accepts a request (REQ1) for enabling a direct memory access data transfer (DMA1) for the transfer of one or more data to the display memory (30) with the highest priority.

3. Method according to claim 1 or 2, characterised in that the direct memory access transfer (DMA1) from the processor memory (7,8) takes place in the burst mode.

4. Method according to one of the preceding claims, characterised in that the microprocessor used in the microprocessor system is a microprocessor (1) for a bus structure (4), a data bus (DBUS) of which comprises a number of bits which is at least as great as the sum of the numbers of bits of two coordinate data, first-type words (W1) consisting of two coordinate data being stored in the processor memory (7,8) and second-type words (W2) consisting of a first-type word (W1) and an associated control datum (CW) being stored in the display memory, the control datum (CW) of each second-type word (W2) having significance for both coordinate data of the second-type word (W2).

5. Method according to claim 4, characterised in that the first-type word (W1) in the display memory (30) consists of two coordinate data of two waveforms (CH1, CH2, REF1, REF2) or of one or two coordinate data of an attribute information dot.

6. Method according to claim 4, characterised in that, in the acquisition memory means (18) first-type words (W1) are stored which each comprise two coordinate data of two respective waveforms (CH1, CH2).

7. Method according to one of the preceding claims, characterised in that the direct memory access transfer (DMA1) to the display memory (30) comprises an alternating transfer of series of coordinate data of waveform dots and of series of coordinate data of attribute information dots.

8. Method according to one of the preceding claims, characterised in that all the dots of each waveform (CH1, CH2, REF1, REF2) to be displayed are displayed before the dots of another waveform are displayed.

9. Method according to one of the preceding claims, characterised in that the control datum (CW) for a coordinate datum of a waveform dot contains a control indication for reading out the display memory (30) with a speed assigned to the indication.

10. Method according to one of claims 1 to 8 inclusive, characterised in that the control datum (CW) for a coordinate datum of a waveform dot contains a control indication for postponing the reading out of the next second-type word (W2) from the display memory (30) for a predetermined delay time and for maintaining the actual level of the sweep signal (SWPDM) during the delay time.

11. Method according to one of claims 1 to 8 inclusive, characterised in that the control datum (CW) of an attribute information dot contains a control indication for the temporary maintenance of the actual level of the sweep signal (SWPDM).

12. Method according to one of claims 1 to 8 inclusive, characterised in that one of the selected deflection signals (UY, UX) is a second-type deflection signal (UX) which is an adjustable direct-voltage signal.

13. Method according to claim 12, characterised in that, in an analog mode, the chosen deflection signals (UY, UX) and further analog signals are alternately delivered to the deflection means.

14. Method according to one of the preceding claims, in which, after a trigger signal (EXTTRIG) has been received and after a predetermined number of coordinate data have then been stored in the acquisition memory (18), the acquisition is postponed and the coordinate data obtained by the acquisition are transferred from the acquisition memory (18) to the display memory means (30), characterised in that the coordinate data stored in the acquisition memory (18) are transferred by means of direct memory access (DMA2) from the acquisition memory (18) to the processor memory (8).

**15.** Method according to claim 14, characterised in that the direct memory access transfer (DMA2) to the processor memory takes place in the cycle steal mode.

**16.** Method according to one of claims 1 to 13 inclusive, characterised in that, in a scan mode, there is continuously, with the read-out speed of the first-in-first-out display memory (30), taken a sample from an input signal (UCH1, UCH2) so as to obtain a coordinate datum of a waveform (CH1, CH2) of the input signal, the coordinate datum is transferred by means of direct memory access (DMA2) as quickly as possible to a location having a rotating write address of an area (71), assigned to the waveform, of the processor memory (8), and, during the direct memory access transfer (DMA1) to the first-in-first-out display memory (30), the transfer always starts from a same location of the area and continues up to and including the last location of the area.

**17.** Method according to one of claims 1 to 13 inclusive, characterised in that, in a roll mode, there is continuously, with the read-out speed of the first-in-first-out display memory (30), taken a sample from an input signal (UCH1, UCH2) so as to obtain a coordinate datum of a waveform (CH1, CH2) of the input signal, the coordinate datum is transferred as quickly as possible by means of direct memory access (DMA2) to a location having a rotating write address of an area (72) assigned to the waveform, of the processor memory (8), the number of coordinate data of the dots, to be displayed of the waveform comprising a smaller subarea than the entire area (72), the write address is initially chosen outside the subarea, the direct memory access transfer (DMA1) to the first-in-first-out display memory (30) starts, for a first dot, to be displayed, of the waveform, from an initial read address beyond the write address and extends over the subarea, and the initial read address is increased for each repeated display of the waveform by a number which is equal to the number of samples taken during the last display of a subarea, always viewed as circulating in the entire area (72).

**18.** Oscilloscope having a cathode ray tube for displaying a waveform (CH1, CH2, REF1, REF2) of at least one input signal (UCH1, UCH2) or of a derivative thereof and attribute information on a screen of the tube, comprising acquisition means for receiving and sampling the at least one input signal (UCH1, UCH2) and for storing, in acquisition memory means (18) of the acquisition means, waveform coordinate data which represent the samples taken or derivatives thereof, display means (30) containing display memory means (30), digital/analog converters (34,35) connected to the display memory means (30), multiplexers (40-43) connected to the converters (34, 35) and to the deflection means for the tube, and control means which are connected to the acquisition memory (18), the display memory means (30), the multiplexers (40-43) and a modulation circuit for modulating the intensity of an electron beam of the tube, the control means transferring the waveform coordinate data from the acquisition memory means (18) to the display memory means (30), the control means storing coordinate data of attribute information in the display memory means (30), the control means reading the data stored in the display memory means (30) in a predetermined sequence and delivering them to the converters (34,35), the multiplexers (40-43) receiving the output signals of the converters (34,35) and a sweep signal (SWPDM) from a sweep generator (45), and the control means controlling the multiplexers (40,43) so as to select and let an analog signal (UY, UX) through to the deflection means, characterised in that the control means comprise a microprocessor system having a bus structure (4), a first direct memory access (DMA1) control circuit (2), a first state machine (32) and a second state machine (33), the first direct memory access control circuit (2) and the acquisition memory means are connected to the bus structure (4), the display memory means comprise a processor memory (7,8) connected to the bus structure (4), a register (9) for storing a control datum (CW) is connected to the bus structure (4), the display memory means also comprise a first-in-first-out (FIFO) display memory (30), data inputs of the first-in-first-out display memory (30) are connected to a data bus (DBUS) of the bus structure (4) and to data outputs of the register (9) so as to receive coordinate data and control data, respectively, data outputs of the first-in-first-out display memory (30) are connected to data inputs of the converters (34,35) and to inputs of the first state machine (32), so as to deliver thereto coordinate data and the control datum (CW), respectively, outputs of the first state machine (32) are connected to control inputs of the multiplexers (40-43), possibly a sweep generator (45), and the modulation circuit, and the second state machine (33) is connected between the first direct memory access control circuit (2) and the first-in-first-out display memory (30).

**19.** Oscilloscope according to claim 18, characterised in that the control means comprise a second direct memory access (DMA2) control circuit (3) which is connected to the bus structure (4) and to the acquisition memory means (18).

**Patentansprüche**

1. Verfahren zur Anzeige einer Wellenform (CH1, CH2, REF1, REF2) wenigstens eines Eingangssignals (UCH1, UCH2) und von Attributinformation auf dem Schirm einer Kathodenstrahlröhre eines Oszilloskops bestehend aus einer Gewinnung von Koordinatendaten, von denen jede eine Koordinate eines anzuzeigenden Abtastpunkts der Wellenform oder eines Punkts der Attributinformation darstellt, Speichern der Koordinatendaten jedes Punkts in einer Erfassungsspeichervorrichtung (18), Übertragen der Punktkoordinatendaten von der Erfassungsspeichervorrichtung (18) zu einer Anzeigespeichervorrichtung (30), Speichern der Punktkoordinatendaten in der Anzeigespeichervorrichtung (30), Auslesen der Punktkoordinatendaten aus der Anzeigespeichervorrichtung (30) mit einer vorbestimmten Geschwindigkeit und in einer vorbestimmten Reihenfolge, Umwandeln jeder gelesenen Punktkoordinatenangabe in ein erstes analoges Ablenksignal (UX), Erzeugung eines zweiten analogen Ablenksignals (UY), das ein Wobbelsignal (SWPDM) sein kann, Auswählen des ersten und zweiten Ablenksignals, von denen eines während der Anzeige einer Wellenform in einem Anzeigemodus, bei dem eine Signalamplitude über der Zeit (Yt) angezeigt wird, das Wobbelsignal ist, und Abgeben des ausgewählten Ablenksignals (UX, UY) an eine Ablenkvorrichtung für die Kathodenstrahlröhre, um deren Elektronenstrahl zu einer Position auf dem Schirm abzulenken, dessen Koordinaten durch die ausgewählten Ablenksignale bestimmt sind, wobei die Intensität des Strahls in der ausgewählten Position als eine Funktion eines Modulationssignals (UZ) moduliert ist, dadurch gekennzeichnet, daß alle Koordinatendaten in einem Prozessorspeicher (7, 8) gespeichert sind, der mit einer Busstruktur (4) eines Mikroprozessorsystems verbunden ist, wobei für das Mikroprozessorsystem ein Anzeigeprogramm assembliert ist, das von einer gewünschten Zusammensetzung eines Bildes auf dem Schirm und von einer gewünschten Reihenfolge der Anzeige der Bildpunkte abhängt, wobei das Anzeigeprogramm in dem Prozessorspeicher (7, 8) gespeichert ist und das Anzeigeprogramm während seines Betriebs Koordinatendaten von anzuzeigenden Punkten aus dem Prozessorspeicher (7, 8) auswählt, wobei jede ausgewählte Koordinatenangabe durch direkten Speicherzugriff (DMA1) vom dem Prozessorspeicher (7, 8) an einen FIFO (first-in-first-out)-Anzeigespeicher (30) übertragen wird, wobei das Anzeigeprogramm für jede ausgewählte Koordinatenangabe eine Anzeigesteuerangabe (CW) bestimmt und diese zur selben Zeit wie eine Koordinatenangabe an den Anzeigespeicher (30) überträgt, wobei die Übertragung an den Anzeigespeicher (30) fortlaufend wiederholt wird, jedoch aufgeschoben wird, falls und solange wie der Anzeigespeicher (30) einen vorbestimmten Grad an Belegung erreicht hat, und wobei jede Steuerangabe (CW) aus dem Anzeigespeicher (30) zusammen mit einer Koordinatenangabe ausgelesen wird, die die Auswahl der Ablenksignale und des Modulationssignals (UZ) bestimmt.

2. Verfahren nach Anspruch 1, dadurch gekennzeichnet, daß das Prozessorsystem eine Anfrage (REQ1) akzeptiert, welche eine Datenübertragung durch direkten Speicherzugriff (DMA1) ermöglicht, um eine oder mehrere Angaben mit höchster Priorität an den Anzeigespeicher (30) zu übertragen.

3. Verfahren nach Anspruch 1 oder 2, dadurch gekennzeichnet, daß die Übertragung durch direkten Speicherzugriff (DMA1) von dem Prozessorspeicher (7, 8) in der Burst-Methode erfolgt.

4. Verfahren nach einem der vorhergehenden Ansprüche, dadurch gekennzeichnet, daß der im Mikroprozessorsystem verwendete Mikroprozessor (1) für eine Busstruktur (4) ausgelegt ist, welche einen Datenbus (DBUS) enthält, der eine Anzahl von Bits umfaßt, die mindestens so groß ist wie die Summe der Bitanzahl zweier Koordinatenangaben, wobei aus zwei Koordinatenangaben bestehende Wörter eines ersten Typs (W1) in dem Prozessorspeicher (7, 8) gespeichert werden und aus einem Wort des ersten Typs (W1) sowie einer damit verbundenen Steuerangabe (CW) bestehende Wörter eines zweiten Typs (W2) in dem Anzeigespeicher gespeichert werden, wobei die Steuerangabe (CW) in jedem Wort des zweiten Typs (W2) für beide Koordinatenangaben in dem Wort des zweiten Typs (W2) bestimmend ist.

5. Verfahren nach Anspruch 4, dadurch gekennzeichnet, daß das Wort des ersten Typs (W1) im Anzeigespeicher (30) aus zwei Koordinatenangaben zweier Wellenformen (CH1, CH2, REF1, REF2) oder aus einer oder zwei Koordinatenangaben eines Punktes der Attributinformation besteht.

6. Verfahren nach Anspruch 4, dadurch gekennzeichnet, daß in der Erfassungsspeichervorrichtung (18) Wörter des ersten Typs (W1) gespeichert werden, von denen jedes zwei Koordinatenangaben von je zwei Wellenformen (CH1, CH2) umfaßt.

7. Verfahren nach einem der vorhergehenden Ansprüche, dadurch gekennzeichnet, daß die Übertragung durch direkten Speicherzugriff (DMA1) an den Anzeigespeicher (30) eine abwechselnde Übertragung von Reihen von die Wellenformpunkte betreffenden Koordinatenangaben und von Reihen von die Attributinformationspunkte betreffenden Koordinatenangaben beinhaltet.

8. Verfahren nach einem der vorhergehenden Ansprüche, dadurch gekennzeichnet, daß alle Punkte einer jeden anzuzeigenden Wellenform (CH1, CH2, REF1, REF2) angezeigt werden, bevor die Punkte einer anderen Wellenform angezeigt werden.

9. Verfahren nach einem der vorhergehenden Ansprüche, dadurch gekennzeichnet, daß die Steuerangabe (CW) für eine Koordinatenangabe eines Wellenformpunktes einen die Geschwindigkeit betreffenden Steuerhinweis für das Lesen aus dem Anzeigespeicher (30) enthält.

10. Verfahren nach einem der Ansprüche 1 bis 8, dadurch gekennzeichnet, daß die Steuerangabe (CW) für eine Koordinatenangabe eines Wellenformpunktes einen Steuerhinweis für den hinsichtlich seiner Verzögerungszeit vorbestimmten Aufschub des Auslesens des nächsten Wortes des zweiten Typs (W2) aus dem Anzeigespeicher (30) sowie für die Aufrechterhaltung des augenblicklichen Pegels des Wobbelsignals (SWPDM) während der Verzögerungszeit enthält.

11. Verfahren nach einem der Ansprüche 1 bis 8, dadurch gekennzeichnet, daß die Steuerangabe (CW) eines Punktes der Attributinformation einen Steuerhinweis für die zeitweilige Aufrechterhaltung des augenblicklichen Pegels des Wobbelsignals (SWPDM) enthält.

12. Verfahren nach einem der Ansprüche 1 bis 8, dadurch gekennzeichnet, daß eines der ausgewählten Ablenksignale (UY, UX) ein Ablenksignal des zweiten Typs (UX) ist, welches ein einstellbares Gleichspannungssignal ist.

13. Verfahren nach Anspruch 12, dadurch gekennzeichnet, daß die ausgewählten Ablenksignale (UY, UX) und weitere Analogsignale abwechselnd in einem Analogmodus an die Ablenkvorrichtung abgegeben werden.

14. Verfahren nach einem der vorhergehenden Ansprüche, gemäß welchem die Erfassung nach Empfang eines Triggersignals (EXTTRIG) und nach darauffolgender Speicherung einer vorbestimmten Anzahl von Koordinatenangaben im Erfassungsspeicher (18) verzögert wird und die bei der Erfassung gewonnenen Koordinatenangaben vom Erfassungsspeicher (18) an die Anzeigespeichervorrichtung (30) übertragen werden, dadurch gekennzeichnet, daß die im Erfassungsspeicher (18) gespeicherten Koordinatenangaben durch direkten Speicherzugriff (DMA2) vom Erfassungsspeicher (18) an den Prozessorspeicher (8) übertragen werden.

15. Verfahren nach Anspruch 14, dadurch gekennzeichnet, daß die Übertragung durch direkten Speicherzugriff (DMA2) an den Prozessorspeicher im Modus des Cycle Stealing (Unterbrechen eines Programms für die Zeitdauer eines Zyklus) erfolgt.

16. Verfahren nach einem der Ansprüche 1 bis 13, dadurch gekennzeichnet, daß in einem Abtastmodus kontinuierlich mit der Lesegeschwindigkeit des FIFO-Anzeigespeichers (30) ein Abtastwert von einem Eingangssignal (UCH1, UCH2) erfaßt wird mit dem Ziel, eine Koordinatenangabe einer Wellenform (CH1, CH2) des Eingangssignals zu erhalten, daß die Koordinatenangabe so schnell wie möglich durch direkten Speicherzugriff (DMA2) an einen Speicherplatz mit rotierender Schreibadresse eines der Wellenform zugewiesenen Speicherbereichs (71) des Prozessorspeichers (8) übertragen wird und daß während der Übertragung durch direkten Speicherzugriff (DMA2) an den FIFO-Anzeigespeicher (30) die Übertragung immer von ein und demselben Speicherplatz des Speicherbereichs aus beginnt und bis zum letzten Speicherplatz, diesen eingeschlossen, fortfährt.

17. Verfahren nach einem der Ansprüche 1 bis 13, dadurch gekennzeichnet, daß in einem Durchlaufmodus kontinuierlich mit der Lesegeschwindigkeit des FIFO-Anzeigespeichers (30) ein Abtastwert von einem Eingangssignal (UCH1, UCH2) erfaßt wird mit dem Ziel, eine Koordinatenangabe einer Wellenform (CH1, CH2) des Eingangssignals zu erhalten, daß die Koordinatenangabe so schnell wie möglich durch direkten Speicherzugriff (DMA2) an einen Speicherplatz mit rotierender Schreibadresse eines der Wellenform zugewiesenen Speicherbereichs (72) des Prozessorspeichers (8) übertragen wird, wobei die Anzahl der Koordinatenangaben der Punkte der Wellenform, die angezeigt werden sollen, einen kleineren Unterbereich des gesamten Bereiches (72) umfaßt, daß die Schreibadresse zu Beginn außerhalb des Unterbereiches gewählt wird, daß für einen ersten anzuzeigenden Punkt der Wellenform die Übertragung durch direkten Speicherzugriff (DMA1) an den FIFO-Anzeigespeicher (30) bei einer Anfangsleseadresse jenseits der Schreibadresse beginnt und sich über den Unterbereich erstreckt und daß die Anfangsleseadresse für jede wiederholte Anzeige der Wellenform um eine Anzahl erhöht wird, die der Anzahl der während der letzten Anzeige aus dem Unterbereich entnommenen Werte entspricht, wobei der Unterbereich stets als im gesamten Speicherbereich (72) zirkulierend angesehen werden kann.

18. Oszilloskop mit einer Kathodenstrahlröhre zur Anzeige einer Wellenform (CH1, CH2, REF1, REF2) von mindestens einem Eingangssignal (UCH1, UCH2) oder einer Ableitung davon und von Attributinformation auf einem Schirm der Röhre, bestehend aus einer Erfassungsvorrichtung zum Empfangen und Abtasten des mindestens einen Eingangssignals (UCH1, UCH2) und zum Speichern von Wellenformkoordinatenangaben in einer Erfassungsspeichervorrichtung (18) der Erfassungsvorrichtung, wobei die Wellenformkoordinatenangaben die abgetasteten Werte oder Ableitungen davon darstellen, Anzeigespeichervorrichtungen (30) enthaltende Anzeigevorrichtungen (30), mit den Anzeigespeichervorrichtungen (30) verbundene D/A-Wandler (34, 35), mit den Wandlern (34, 35) und den Ablenkvorrichtungen für die Röhre verbundene Multiplexer (40-43) sowie eine Steuervorrichtung, die mit dem Erfassungsspeicher (18), dem Anzeigespeicher (30), den Multiplexern (40-43) und einem Modulationsschaltkreis zur Modulation der Intensität eines Elektronenstrahls der Röhre verbunden ist, wobei die Steuervorrichtung die Wellenformkoordinatenangaben von der Erfassungsspeichervorrichtung (18) an die Anzeigespeichervorrichtung (30) überträgt, Koordinatendaten der Attributinformation in der Anzeigespeichervorrichtung speichert, die in der Anzeigespeichervorrichtung (30) gespeicherten Daten in einer vorbestimmten Reihenfolge liest und sie an die Wandler (34, 35) weitergibt, wobei die Multiplexer (40-43) die Ausgangssignale der Wandler (34, 35) und ein Wobbelsignal (SWPDM) von einem Wobbelgenerator (45) empfangen und die Steuervorrichtung die Multiplexer (40-43) in der Weise steuert, daß ein Analogsignal (UY, UX) ausgewählt und an die Ablenkvorrichtung durchgelassen wird, dadurch gekennzeichnet, daß die Steuervorrichtung ein Mikroprozessorsystem umfaßt, das eine Busstruktur (4), einen ersten Steuerschaltkreis (2) mit direktem Speicherzugriff (DMA1), eine erste Zustandsmaschine (32) und eine zweite Zustandsmaschine (32) aufweist, daß der erste Steuerschaltkreis (2) mit direktem Speicherzugriff und die Erfassungsspeichervorrichtung mit der Busstruktur (4) verbunden sind, daß die Anzeigespeichervorrichtung einen mit der Busstruktur (4) verbundenen Prozessorspeicher (7, 8) umfaßt, daß ein Register (9) zur Speicherung einer Steuerangabe (CW) mit der Busstruktur (4) verbunden ist, daß die Anzeigespeichervorrichtung auch einen FIFO-Anzeigespeicher (30) umfaßt, daß Dateneingänge des FIFO-Anzeigespeichers (30) mit einem Datenbus (DBUS) der Busstruktur (4) und mit Datenausgängen des Registers (9) derart verbunden sind, daß sie Koordinatenangaben beziehungsweise Steuerangaben empfangen, daß Datenausgänge des FIFO-Anzeigespeichers (30) mit Dateneingängen der Wandler (34, 35) und mit Eingängen der ersten Zustandsmaschine (32) derart verbunden sind, daß sie dorthin Koordinatenangaben beziehungsweise die Steuerangabe (CW) abgeben können, daß Ausgänge der ersten Zustandsmaschine (32) mit Steuereingängen der Multiplexer (40-43), möglicherweise mit einem Wobbelgenerator (45), und dem Modulationsschaltkreis verbunden sind und daß die zweite Zustandsmaschine (33) zwischen dem ersten Steuerschaltkreis (2) mit direktem Speicherzugriff und dem FIFO-Anzeigespeicher (30) geschaltet ist.

19. Oszilloskop nach Anspruch 18, dadurch gekennzeichnet, daß die Steuervorrichtung einen zweiten Steuerschaltkreis (3) mit direktem Speicherzugriff (DMA2), der mit der Busstruktur (4) und der Erfassungsspeichervorrichtung (18) verbunden ist, umfaßt.

## Revendications

1. Procédé d'affichage d'une forme d'onde (CH1, CH2, REF1, REF2) d'au moins un signal d'entrée (UCH1, UCH2) et d'une information d'attribut sur un écran d'un tube à rayons cathodiques d'un oscilloscope, comprenant : l'obtention de données de coordonnée, qui représentent chacune une coordonnée d'un point d'échantillon à afficher de la forme d'onde, ou d'un point de l'information d'attribut ; la mémorisation des données de coordonnée de chaque point dans un moyen de mémorisation d'acquisition (18) ; le transfert des données de coordonnée de point du moyen de mémorisation d'acquisition (18) à un moyen de mémorisation d'affichage (30) ; la mémorisation des données de coordonnée de point dans le moyen de mémorisation d'affichage (30) ; la lecture des données de coordonnée de point dans le moyen de mémorisation d'affichage (30) à une vitesse prédéterminée et suivant une séquence prédéterminée ; la conversion de chaque donnée de coordonnée de point lue en un premier signal de déviation analogique (UX) ;

la production d'un second signal de déviation analogique (UY), qui peut être un signal de balayage (SWPDM) ; le choix desdits premier et second signaux de déviation, dont l'un est le signal de balayage pendant l'affichage d'une forme d'onde dans un mode d'affichage d'amplitude de signal par rapport au temps (Yt) ; et la délivrance des signaux de déviation (UX, UY) à un moyen de déviation du tube à rayons cathodiques de manière à dévier son faisceau d'électrons vers une position sur l'écran dont les coordonnées sont déterminées par les signaux de déviation choisis, l'intensité du faisceau dans la position choisie étant modulée en fonction d'un signal de modulation (UZ) ;

caractérisé en ce que toutes les données de coordonnée sont mémorisées dans une mémoire de processeur (7, 8) qui est connectée à une structure de bus (4) d'un système microprocesseur ; en ce qu'un programme d'affichage est assemblé pour le système microprocesseur, lequel programme d'affichage dépend de la composition souhaitée d'une image sur l'écran et d'une séquence d'affichage souhaitée des points d'image ; en ce que le programme d'affichage est mémorisé dans la mémoire de processeur (7, 8) ; en ce que le programme d'affichage choisit, pendant son fonctionnement, des données de coordonnée de points à afficher à partir de la mémoire de processeurs (7, 8) ; en ce que chaque donnée de coordonnée choisie est transférée au moyen d'un accès direct en mémoire (DMA1), de la mémoire de processeur (7, 8) à une mémoire d'affichage du type premier-entré-premier-sorti (FIFO) (30) ; en ce que le programme d'affichage détermine, pour chaque donnée de coordonnée choisie, une donnée de commande d'affichage (CW) et la transfère en même temps que la donnée de coordonnée vers la mémoire d'affichage (30) ; en ce que le transfert vers la mémoire d'affichage (30) est répété de manière continue mais retardé si, et aussi longtemps que, la mémoire d'affichage (30) a atteint un degré d'occupation prédéterminé, et en ce que chaque donnée de commande (CW) est lue dans la mémoire d'affichage (30) en même temps qu'une donnée de coordonnée déterminant le choix des signaux de déviation et du signal de modulation (UZ).

2. Procédé selon la revendication 1, caractérisé en ce que le système processeur accepte une demande (REQ1) pour autoriser un transfert de données avec accès direct en mémoire (DMA1) pour le transfert d'une ou plusieurs données vers la mémoire d'affichage (30) avec la priorité la plus élevée.

3. Procédé selon la revendication 1 ou 2, caractérisé en ce que le transfert avec accès direct en mémoire (DMA1) à partir de la mémoire de processeur (7, 8) s'effectue dans le mode en salves.

4. Procédé selon l'une des revendications précédentes, caractérisé en ce que le microprocesseur utilisé dans le système microprocesseur est un microprocesseur (1) pour une structure de bus (4), dont un bus de données (DBUS) comprend un certain nombre de bus qui est au moins aussi grand que la somme des nombres de bits des deux données de coordonnée ; des mots d'un premier type (W1), constitués de deux données de coordonnée qui sont mémorisées dans la mémoire de processeur (7, 8), et des mots d'un second type (W2), constitués d'un mot du premier type (W1) et d'une donnée de commande associée (CW), étant mémorisés dans la mémoire d'affichage ; la donnée de commande (CW) de chaque mot du second type (W2) ayant une signification pour les deux données de coordonnée du mot du second type (W2).

5. Procédé selon la revendication 4, caractérisé en ce que le mot du premier type (W1) dans la mémoire d'affichage (30) est constitué de deux données de coordonnée de deux formes d'onde (CH1, CH2, REF1, REF2) ou d'une ou deux données de coordonnée d'un point d'information d'attribut.

6. Procédé selon la revendication 4, caractérisé en ce que des mots du premier type (W1), qui comprennent chacun deux données de coordonnée de deux formes d'onde respectives (CH1, CH2), sont mémorisés dans le moyen de mémorisation d'acquisition (18).

7. Procédé selon l'une des revendications précédentes, caractérisé en ce que le transfert avec accès direct en mémoire (DMA1) vers la mémoire d'affichage (30) comprend un transfert alterné de séries de données de coordonnée de points de forme d'onde et de séries de données de coordonnée de points d'information d'attribut.

8. Procédé selon l'une des revendications précédentes, caractérisé en ce que tous les points de chaque forme d'onde (CH1, CH2, REF1, REF2) à afficher sont affichés avant l'affichage des points d'une autre forme.

9. Procédé selon l'une des revendications précédentes, caractérisé en ce que la donnée de commande (CW) pour une donnée de coordonnée d'un point de forme d'onde contient une indication de commande pour lire la mémoire d'affichage (30) avec une vitesse imposée dans l'indication.

10. Procédé selon l'une des revendications 1 à 8, inclusivement, caractérisé en ce que caractérisé en ce que la donnée de commande (CW) pour une donnée de coordonnée d'un point de forme d'onde contient une indication de commande pour différer la lecture du mot du second type (W2) suivant de la mémoire d'affichage (30) pendant un temps de retard prédéterminé et pour maintenir le niveau réel du signal de balayage (SWPDM) pendant la durée du retard.

11. Procédé selon l'une des revendications 1 à 8 inclusivement, caractérisé en ce que la donnée de commande (CW) d'un point d'information d'attribut contient une indication de commande pour le maintien temporaire du niveau réel du signal de balayage (SWPDM).

12. Procédé selon l'une des revendications 1 à 8 inclusivement, caractérisé en ce que l'un des signaux de déviation (UY, UX) choisi est un signal de déviation d'un second type (UX) qui est un signal de tension continue réglable.

13. Procédé selon la revendication 12, caractérisé en ce que, dans un mode analogique, les signaux de déviation (UY, UX) choisis et d'autres signaux analogiques sont délivrés de manière alternée au moyen de déviation.

14. Procédé selon l'une des revendications précédentes, dans lequel, après qu'un signal de déclenchement (EXTTRIG) a été reçu et après qu'un nombre prédéterminé de données de coordonnée a été ensuite mémorisé dans la mémoire d'acquisition (18), l'acquisition est différée et les données de coordonnée obtenues par l'acquisition sont transférées de la mémoire d'acquisition (18) vers le moyen de mémorisation d'affichage (30), caractérisé en ce que les données de coordonnée mémorisées dans la mémoire d'acquisition (18) sont transférées au moyen d'un accès direct en mémoire (DMA2) de la mémoire d'acquisition (18) à la mémoire de processeur (8).

15. Procédé selon la revendication 14, caractérisé en ce que le transfert avec accès direct en mémoire (DMA2) vers la mémoire de processeur se produit dans un mode de vol de cycle.

16. Procédé selon l'une des revendications 1 à 13 inclusivement, caractérisé en ce que, dans un mode de balayage, on prélève de manière continuelle, avec la vitesse de lecture de la mémoire d'affichage du type premier-entré-premier-sorti (30), un échantillon provenant d'un signal d'entrée (UCH1, UCH2) de manière à obtenir une donnée de coordonnée d'une forme d'onde (CH1, CH2) du signal d'entrée ; en ce que la donnée de coordonnée est transférée au moyen d'un accès direct en mémoire (DMA2) aussi rapidement que possible à un emplacement ayant une adresse d'écriture tournante d'une zone (71), affectée à la forme d'onde, de la mémoire de processeur (8) ; et en ce que, durant le transfert avec accès direct en mémoire (DMA1) vers la mémoire d'affichage du type premier-entré-premier-sorti (30), le transfert démarre toujours à partir du même emplacement de la zone et se poursuit jusqu'au dernier emplacement de la zone, inclusivement.

17. Procédé selon l'une des revendications 1 à 13 inclusivement, caractérisé en ce que, dans un mode de défilement, on prélève de manière continuelle, avec la vitesse de lecture de la mémoire d'affichage du type premier-entré-premier-sorti (30), un échantillon provenant d'un signal d'entrée (UCH1, UCH2) de manière à obtenir une donnée de coordonnée d'une forme d'onde (CH1, CH2) du signal d'entrée ; en ce que la donnée de coordonnée est transférée aussi rapidement que possible au moyen d'un accès direct en mémoire (DMA2) à un emplacement ayant une adresse d'écriture tournante d'une zone (72), affectée à la forme d'onde, de la mémoire de processeur (8), le nombre de données de coordonnée des points à afficher de la forme d'onde comprenant une sous-zone plus petite que la zone complète (72) ; en ce que l'adresse d'écriture est choisie initialement à l'extérieur de la sous-zone ; en ce que le transfert avec accès direct en mémoire (DMA1) vers la mémoire d'affichage du type premier-entré-premier-sorti (30) commence, pour un premier point à afficher de la forme d'onde, à partir d'une adresse de lecture initiale au-delà de l'adresse d'écriture et s'étend sur la sous-zone ; et en ce que l'adresse de lecture initiale est incrémentée, pour chaque affichage répété de la forme d'onde, d'un nombre qui est égal au nombre d'échantillons prélevés pendant le dernier affichage d'une sous-zone, toujours vue comme circulant dans toute la zone (72).

18. Oscilloscope comportant un tube à rayons cathodiques pour afficher une forme d'onde (CH1, CH2, REF1, REF2) d'au moins un signal d'entrée (UCH1, UCH2), ou d'un dérivé de celui-ci, et une information d'attribut sur un écran du tube, comprenant : un moyen d'acquisition pour recevoir et échantillonner au moins un signal d'entrée (UCH1, UCH2) et pour mémoriser, dans un moyen de mémorisation d'acquisition (18) du moyen d'acquisition, des données de coordonnée de forme d'onde qui représentent les échantillons prélevés, ou des dérivés de ceux-ci ; un moyen d'affichage (30) contenant le moyen de mémorisation d'affichage (30) ; des convertisseurs de numérique en analogique (34, 35) connectés au moyen de mémorisation d'affichage (30) ; des multiplexeurs (40 à 43) connectés aux convertisseurs (34, 35) et au moyen de déviation du tube ; et un moyen de commande qui est connecté à la mémoire d'acquisition (18), au moyen de mémorisation d'affichage (30), aux multiplexeurs (40 à 43) et à un circuit de modulation pour moduler l'intensité d'un faisceau d'électrons du tube, le moyen de commande transférant les données de coordonnée de forme d'onde du moyen de mémorisation d'acquisition (18) au moyen de mémorisation d'affichage (30), le moyen de commande mémorisant les données de coordonnée d'information d'attribut dans le moyen de mémorisation d'affichage (30), le moyen de commande lisant les données mémorisées dans le moyen de mémorisation d'affichage (30) suivant une séquence prédéterminée et les délivrant aux convertisseurs (34, 35), les multiplexeurs (40 à 43) recevant les signaux de sortie des convertisseurs (34, 35) et un signal de balayage (SWPDM) d'un générateur de balayage (45), et le moyen de commande commandant les multiplexeurs (40 à 43) de manière à choisir et à laisser passer un signal analogique (UY, UX) vers le moyen de déviation ; caractérisé en ce que le moyen de commande comprend un système de microprocesseur ayant une structure de bus (4), un premier circuit de commande (2) d'un accès direct en mémoire (DMA1), un premier automate fini (32) et un second automate fini (33) ; en ce que le premier circuit de commande d'accès direct en mémoire (2) et le moyen de mémorisation d'acquisition sont connectés à la structure de bus (4) ; en ce que le moyen de mémorisation d'affichage comprend une mémoire de processeur (7, 8) connectée à la structure de bus (4) ; en ce qu'un registre (9) pour mémoriser une donnée de commande (CW) est connecté à la structure de bus (4) ; en ce que le moyen de mémorisation d'affichage comprend également une mémoire d'affichage du type premier-entré-premier-sorti (FIFO) (30) ; en ce que les entrées de données de la mémoire d'affichage du type premier-entré-premier-sorti (30) sont connectées à un bus de données (DBUS) de la structure de bus (4) et aux sorties de données du registre (9), de manière à recevoir, respectivement, des données de coordonnée et des données de commande ; en ce que les sorties de données de la mémoire d'affichage du type premier-entré-premier-sorti (30) sont connectées à des entrées de donnée des convertisseurs (34, 35) et à des entrées du premier automate fini (32), de manière à leur délivrer, respectivement, des données de coordonnée et la donnée de commande (CW) ; en ce que les sorties du premier automate fini (32) sont connectées à des entrées de commande des multiplexeurs (40 à 43), éventuellement à un générateur de balayage (45), et au circuit de modulation ; et ce que le second automate fini (33) est connecté entre le premier circuit de commande d'accès direct en mémoire (2) et la mémoire d'affichage du type premier-entré-premier-sorti (30).

19. Oscilloscope selon la revendication 18, caractérisé en ce que le moyen de commande comprend un second circuit de commande (3) d'accès direct en mémoire (DMA2) qui est connecté à la structure de bus (4) et au moyen de mémorisation d'acquisition (18).

$$\underline{\underline{Fig:1a}}$$

UCH1

UCH2

RES

ACK1
REQ1

33

STATE MACH.

31

OSC

SIN
SOUT

TO Z-
MODULATOR
UZ

W2

32

FIFO MEMORY

CW

STATE MACHINE

URS

44

30

n=2m

34

DAC

m

40

MUX

47

ADD

42

MUX

UY

35

DAC

m

41

MUX

43

MUX

UX

UF1

SWPDM

SWPAM

46

DAC &
AN. HOLD
CIRCUIT

45

AN.
SWEEP
GEN.

48

AN.
SWEEP
GEN.

CBUS
ABUS
DBUS

CBUS
ABUS
DBUS

UF2    RESSW    HOLD

_Fig. 16_

SWPDM

t0:t1  t2 t3 t4  t5  t6 t7

TIME CURSOR 1

TRIG POINT

PART 1 OF TEXT & OTHERS

CH1

PART 2 OF TEXT & OTHERS

CH2

t8 t9 t10

TIME CURSOR 2

t11 t12

PART 3 OF TEXT & OTHERS

REF1

t13 t14

PART 4 OF TEXT & OTHERS

REF2

t

*Fig.2*

BEGIN

FROM FIG. 3b — 50

```
CW = 32
DMA1 POINTER = 1st LOCATION TEXT FIELD
DMA1 COUNT   = NUMBER OF PART 1 OF TEXT
START DMA1
```

— 51

```
CW = F4
DMA1 POINTER = 1st LOCATION CH1 FIELD
DMA1 COUNT   = NUMBER OF CH1 TO t2
START DMA1
```

— 52

```
CW = B8
DMA1 POINTER = SUBSEQUENT LOCATION CH1 FIELD
DMA1 COUNT   = 1
START DMA1
```

— 53

```
CW = F4
DMA1 POINTER = SUBSEQUENT LOCATION CH1 FIELD
DMA1 COUNT   = SUBSEQUENT NUMBER OF CH1 TO t4
START DMA1
```

— 54

```
CW = 80
DMA1 POINTER = 1st LOCATION TIME CURSOR 1 PATTERN
DMA1 COUNT   = NUMBER OF DOTS CURSOR 1
START DMA1
```

— 55

```
CW = F4
DMA1 POINTER = SUBSEQUENT LOCATION CH1 FIELD
DMA1 COUNT   = SUBSEQUENT NUMBER OF CH1 TO t6
START DMA1
```

— 56

```
CW = 32
DMA1 POINTER = SUBSEQUENT LOCATION TEXT FIELD
DMA1 COUNT   = NUMBER OF PART 2 OF TEXT
START DMA1
```

TO FIG. 3b

FIG.3a

FROM FIG. 3a

~57

```
CW = D4
DMA1 POINTER = 1st LOCATION CH2 FIELD
DMA1 COUNT   = NUMBER OF CH2 TO t8
START DMA1
```

~58

```
CW = 80
DMA1 POINTER = 1st LOCATION TIME CURSOR 2 PATTERN
DMA1 COUNT   = NUMBER OF DOTS CURSOR 2
START DMA1
```

~59

```
CW = D4
DMA1 POINTER = SUBSEQUENT LOCATION CH2 FIELD
DMA1 COUNT   = SUBSEQUENT NUMBER OF CH2 TO t10
START DMA1
```

~60

```
CW = 32
DMA1 POINTER = SUBSEQUENT LOCATION TEXT FIELD
DMA1 COUNT   = NUMBER OF PART 3 OF TEXT
START DMA1
```

~61

```
CW = E4
DMA1 POINTER = 1st LOCATION REF1 FIELD
DMA1 COUNT   = NUMBER OF REF1
START DMA1
```

~62

```
CW = 32
DMA1 POINTER = SUBSEQUENT LOCATION TEXT FIELD
DMA1 COUNT   = NUMBER OF PART 4 OF TEXT
START DMA1
```

~63

```
CW = C4
DMA1 POINTER = 1st LOCATION REF2 FIELD
DMA1 COUNT   = NUMBER OF REF2
START DMA1
```

TO FIG. 3a

FIG. 3b

_Fig:4_

_Fig:5a_

_Fig:5b_

_Fig:5c_

_Fig:7a_

_Fig:7b_

_Fig:7c_

| d5 |
| d6 |
| d7 |
| d8 |
| d9 |
| d10 |
| d1 |
| d2 |
| d3 |
| d4 |

71

Fig.6a

| d5 |
| d6 |
| d7 |
| d8 |
| d9 |
| d10 |
| d11 |
| d2 |
| d3 |
| d4 |

71

Fig.6b

| d5 |
| d6 |
| d7 |
| d8 |
| d9 |
| d10 |
| d11 |
| d12 |
| d3 |
| d4 |

71

Fig.6c

| d5 |
| d6 |
| d7 |
| d8 |
| d9 |
| d10 |
| d11 |
| |
| d1 |
| d2 |
| d3 |
| d4 |

72

Fig.6a

| d5 |
| d6 |
| d7 |
| d8 |
| d9 |
| d10 |
| d11 |
| d12 |
| |
| d2 |
| d3 |
| d4 |

72

Fig.6b

| d5 |
| d6 |
| d7 |
| d8 |
| d9 |
| d10 |
| d11 |
| d12 |
| d13 |
| |
| d3 |
| d4 |

72

Fig.6c